(19)

Europäisches
Patentamt

European
Patent Office

Office européen
des brevets

(11) **EP 2 658 006 B1**

(12) **EUROPEAN PATENT SPECIFICATION**

(45) Date of publication and mention
of the grant of the patent:
**20.05.2015 Bulletin 2015/21**

(51) Int Cl.:
***H01L 51/05*** *(2006.01)*

(21) Application number: **12166029.4**

(22) Date of filing: **27.04.2012**

(54) **Organic field effect transistor**

Organischer Feldeffekttransistor

Transistor à effet de champ organique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**30.10.2013 Bulletin 2013/44**

(73) Proprietors:
• **Novaled GmbH**
**01307 Dresden (DE)**
• **Technische Universität Dresden**
**01062 Dresden (DE)**

(72) Inventors:
• **Lüssem, Björn**
**01127 Dresden (DE)**

• **Kleemann, Hans**
**01099 Dresden (DE)**
• **Leo, Karl**
**01219 Dresden (DE)**
• **Zakhidov, Alexander**
**01069 Dresden (DE)**

(74) Representative: **Bittner, Thomas L.**
**Boehmert & Boehmert**
**Anwaltspartnerschaft mbB**
**Patentanwälte Rechtsanwälte**
**Pettenkoferstrasse 20-22**
**80336 München (DE)**

(56) References cited:
**WO-A1-2009/062457     WO-A2-2006/040548
US-A1- 2005 242 342     US-A1- 2006 033 098
US-A1- 2009 315 455**

**Description**

The invention relates to an organic field effect transistor.

Background of the invention

Ever since the invention of organic field effect transistors (OFETs) in the 1980s their performance could be continuously improved. Nowadays, OFETs are used for driving e-ink displays, printed RFID tags, and flexible electronics. The advantages of OFETs compared to silicon technology are the possibility to realize thin and flexible circuits at low process temperatures on large areas.

In general, an organic field effect transistor comprises a gate electrode, a source electrode and a drain electrode. Further, the OFET comprises an organic semiconductor and a gate insulator which separates the gate electrode from the organic semiconductor.

Despite the progress, the widespread application of OFETs is still limited due to their low performance and stability. However, there is a large potential for improvement by the development of advanced OFET structures.

Although the organic doping technology has been shown to be a key technology for highly efficient opto-electronic devices, the use of doped organic layers in organic transistors is much less common.

There are three different approaches to improve the performance of OFETs.

Contact doping: For example, doping can be used to reduce the contact resistance at the source and drain electrodes. A thin p- or n-doped layer between the metallic electrodes and the organic semiconductor forms an ohmic contact which increases the tunnel currents and enhances the injection of charge carriers.

Depletion type OFETs: Some groups also reported on the effects of channel doping on the OFET performance. For example, it is possible to switch pentacene transistors from p-type to n-type using a thin layer of Ca at the oxide surface, which acts as a local dopant and fills electron traps at the interface between the organic semiconductor and the gate insulator. It was shown that doping the channel of an n-OFET by an air-stable n-dopant can increase the air-stability of n-type transistors.

Furthermore, it has been reported that the threshold voltage can be shifted by the doping concentration. Meijer et al. Journal of Applied Physics, vol. 93, no. 8, p. 4831, 2003, studied the effect of doping by oxygen exposure on polymer transistors. Although they observe a shift of the switch-on voltage (the flatband voltage), they state that this effect is not related to doping. Similarly, other authors found a similar shift of threshold voltage with doping concentration, but often this effect is rather related to the influence of contact doping than to channel doping.

In all these reports on doped OFETs, the transistor is a *depletion type OFET*. Although the threshold voltage is not well defined for these transistors, it can be approximated by the flatband voltage $V_{FB}$. Following standard semiconductor theory, the shift of the flatband voltage $V_{FB}$ is given by (neglecting interface and oxide traps, for p-type transistors):

$$eV_{FB} = E_{HOMO} - \eta - W_f \qquad \text{(Eq. 1)}$$

wherein $E_{HOMO}$ is the HOMO (highest occupied molecular orbital) position of the organic semiconductor, $W_f$ is the work function of the gate metal and $\eta$ is the energy gap between the HOMO and the Fermi Energy. By doping, the position of the Fermi Energy (i.e. $\eta$) can be controlled. Thus, following Eq. 1, the flatband voltage can be controlled by the shift of $\eta$ due to doping. However, a disadvantage of the depletion OFETs reported so far is the increase of the OFF-state currents, which usually leads to a poor transistor performance.

Inversion type OFETs: Inversion FETs are normally OFF and an inversion channel has to be formed by an applied gate voltage in order to switch the transistor ON. Inversion FETs are used in CMOS circuits and are the most basic building block of all integrated circuits. Strengths of inversion OFETs are a tuneable threshold voltage and a reduction of leakage currents.

It is known that the inversion regime cannot be reached in organic MIS (metal insulator semiconductor) capacitors, it has been predicted by simulations that an inversion channel can be formed in FET structures, if minority carriers are injected at the source and drain electrodes. Huang et al. Journal of Applied Physics, vol. 100, no. 11, p. 114512, 2006, could show that a normally n-conducting intrinsic material can be made p-conductive by charging the gate insulator prior to deposition of the organic layer by a corona discharge.

Summary of the invention

Document WO 2006/040548 A2 discloses an organic transistor comprising source electrode and drain electrodes, a gate electrode, an organic insulating layer between the gate electrode and the source and drain electrodes, and an organic semiconductive region between the insulating layer and the source and drain electrodes. The organic semiconductive region comprises a high mobility layer of an organic semiconductor and a blocking layer of an organic material positioned between the high mobility layer and the source and drain electrodes.

Document US 2009/0315455 A1 discloses an organic light emitting diode including a substrate and an organic thin film transistor on the substrate. The transistor includes a gate, an insulating layer covering the gate, and a channel layer arranged on the insulating layer corresponding to the gate. The channel layer includes a doped layer.

Document US 2006/0033098A1 discloses an organic semiconductor based device and a method for producing the device.

Document US 2005/0242342A1 discloses an organic thin film transistor including an organic semiconductor film, source and drain electrodes, a gate electrode insulated from the source and drain electrodes, an organic semiconductor film and an organic acceptor film interposed between the source and drain electrodes and the organic semiconductor film. The organic acceptor film can comprise an organic semiconductor material and an organic acceptor material.

Document WO 2009/062457A1 discloses an organic field effect transistor.

It is the object of the invention to provide an organic field effect transistor with a tuneable threshold voltage.

This object is solved by the organic field effect transistor according to claim 1. Advantageous embodiments of the invention are the subject of dependent claims.

According to one aspect of the invention, an organic field effect transistor is provided. The transistor comprises a first electrode and a second electrode, the electrodes providing a source electrode and a drain electrode, an intrinsic organic semiconducting layer in electrical contact with the first and second electrode, a gate electrode, a gate insulator provided between the gate electrode and the intrinsic organic semiconducting layer, and a doped organic semiconducting layer provided between the gate insulator and the intrinsic organic semiconducting layer. A charge carrier channel is formed between the first and second electrode in the doped organic semiconducting layer.

With the invention, an inversion OFET is realized by a doped organic semiconducting layer leading to a doped charge carrier channel. Hereby, a solution for the Off-state current problem of depletion type OFETs and a method to increase the shift of the threshold voltage is provided. The shift of the threshold voltage $V_{th}$ for inversion FETs is given by

$$V_{th} = V_{FB} + 2\Phi_F + \gamma\sqrt{2\Phi_F + V_{SB}}$$

$$\gamma = \frac{1}{C'_{ox}}\sqrt{2eN_D\varepsilon_0\varepsilon_r} \qquad (Eq.\ 2)$$

wherein $\Phi_F$ is the energy gap between the intrinsic Fermi level position and the Fermi Level position of the doped organic layer, $V_{SB}$ is the voltage between source and bulk, $C'_{ox}$ is the gate capacitance (per unit area), $N_D$ is the doping concentration, $\varepsilon_r$ is the permittivity of the organic layer, $\varepsilon_0$ is the vacuum permittivity and e is the elementary charge. The permittivity is related to the polarizability of an organic semiconductor. Typical values of $\varepsilon_r$ for organic materials vary between 2.5 and 7. It is obvious that the influence of doping on the shift of the threshold voltage for the inversion OFET is much stronger than that of depletion type OFETs.

The first and second electrodes can inject either electrons or holes into the intrinsic semiconducting layer.

The inversion type organic field effect transistor according to the invention has the following advantages:

- The threshold voltage is precisely tuneable by the doping concentration in the doped organic semiconducting layer.
- Despite the doped channel, the transistors show a large ON/OFF ratio.
- The current in the linear regime is tuneable by the doping concentration.
- The transistor structures can be processed by standard vacuum or solution based deposition processes.
- The transistor structures are scalable in lateral dimensions by shadow masks, lithography, ink-jet printing, laser structuring or other structuring methods.

In a preferred embodiment of the method, the intrinsic organic semiconducting layer and the doped organic semiconducting layer comprise the same organic matrix material.

In still another preferred embodiment of the method, at least one of the first and second electrodes is configured to inject minority charge carriers into the charge carrier channel.

An injection layer is provided adjacent to at least one of the first and second electrode. The injection layer, improves injection of minority carriers from the first and/or second electrode into the inversion channel, respectively.

The injection layer is doped with a dopant of opposite type than a dopant of the doped organic semiconducting layer. The doped semiconducting layer has to be n-doped for p-doped injection layers and p-doped for n-doped injection layers.

In a preferred embodiment of the invention, a mixed layer comprising a hole transport material and an electron transport material is provided in electrical contact with at least one of the first and second electrode. The mixed layer can be realized by a co-evaporated layer of a hole and an electron transporting material such as pentacene or C60, respectively. Alternatively, the mixed layer can be formed by evaporation of the injection layer(s) or the first and second electrode onto a rough, polycrystalline material such as e.g. pentacene. The injection layers or the first and / or second electrode will fill the grooves between the crystallites of the semiconductor and the mixed layer is formed.

The host/dopant system is typically chosen with respect to the energy levels of a host and a dopant material. For a preferable combination of host and dopant the activation energy required for doping is less than the 50 meV. Such activation energy can be determined by temperature dependent capacitance-voltage measurements. Low activation energy is preferable since this guarantees a temperature independent threshold voltage of the inversion FET.

The dopant is preferably an electrical dopant. Electrical dopants are classified in p-dopants and n-dopants. Electrical doping is well known in the field, exemplary literature references are Gao et al, Appl. Phys. Lett. V.79, p.4040 (2001), Blochwitz et al, Appl. Phys. Lett. V.73, p.729 (1998), D'Andrade et al. App. Phys. Let. V.83, p. 3858 (2003), Walzer et al. Chcm. Rev. V. 107, p.1233 (2007), US2005040390A1, US2009179189A. Preferred compounds are organic molecules containing cyano groups.

Exemplary p-dopants are:

- tetrafluoro-tetracyanoquinonedimethane (F4TCNQ),
- 2,2'-(perfluoronaphthalene-2,6-diylidene) dimalononitrile, and
- 2,2',2"-(cyclopropane-1,2,3-triylidene)tris(2-(p-cyanotctrafluorophenyl)acetonitrile).

Exemplary n-dopants are:

- acridine orange base (AOB),

- tetrakis (1,3,4,6,7,8 - hexahydro - 2H - pyrimido [1,2-a] pyrimidinato)ditungsten (II) (W2(hpp)4),

- 3,6-bis-(dimethyl amino)-acridine, and

- bis(ethylene-dithio) tetrathiafulvalene (BEDT-TTF).

Preferable host-dopant combinations are (Table 1):

| host (matrix material) | dopant |
| --- | --- |
| N4,N4,N4',N4'-tetrakis(4-methoxyphenyl)biphenyl-4,4'-diamine (Meo-TPD) | 2,2'-(perfluoronaphthalene-2,6-diylidene)dimalononitrile (F6-TCNNQ) |
| Meo-TPD | F4-TCNQ |
| Meo-TPD | C60F36 |
| Pentacene | F6-TCNNQ |
| Tris(1-phenylisoquinoline)iridium(III) (Ir(piq)3) | F6-TCNNQ |
| Pentacene | F4-TCNQ |
| C60 | W2(hpp)4 |
| C60 | Cr2(hpp)4 |
| C60 | AOB |
| Pentacene | W2(hpp)4 |
| Copper(II)-1,2,3,4,8,9,10,11,15,16,17,18, 22,23,24,25-hexadecafluor-29H,31 H-phthalocyanin (F16CuPc) | W2(hpp)4 |

In one preferred embodiment, the thickness of the doped organic semiconducting layer is between 1 nm and 20 nm. Preferably, the thickness of the doped organic semiconducting layer is between 2 nm and 10 nm.

In still a further embodiment, the doped organic semiconducting layer has a dopant concentration of up to 4 wt%. Preferably, the dopant concentration is between 0.5 wt% and 2 wt%.

The thickness of the doped organic semiconducting layer and the concentration of the dopant in the doped organic semiconducting layer are configured to enable a conducting channel of minority charge carrier type at the gate interface. It is configured to enable a variable threshold voltage $V_{th}$ in inversion mode. The threshold voltage of the transistor can be (freely) set by the doping concentration. The thickness of the doped organic semiconducting layer should be sufficiently thick to form a closed layer. "Closed" means that the layer has no interruptions (regions with a lack of layer material).

The thickness of the doped organic semiconducting layer and the concentration of the dopant in the doped organic semiconducting layer are also configured to enable a high $I_{DS}$ ON/OFF ratio of at least four orders of magnitude in inversion mode under normal voltage operating condition. Preferably, the ON/OFF ratio is higher than five orders of magnitude.

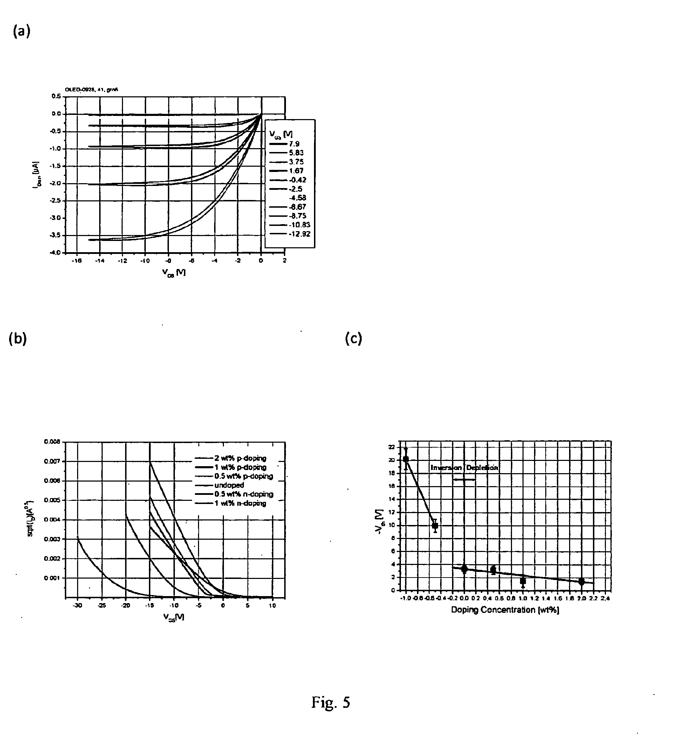

The doping concentration in the doped channel has to be chosen in dependence of the targeted threshold voltages. For example, an n-doping concentration of 0.5 wt% results in a threshold voltage of 10 V and a n-doping concentration of 1 wt% leads to a threshold voltage of 20 V (see Fig. 5c and Eq. 2). To reduce parasitic leakage currents in the transistor, the doped organic semiconducting layer has to be as thin as possible. On the other hand, it has to be thick enough to form a closed layer and to control the Fermi Level in the doped organic semiconducting layer.

Preferably, the intrinsic organic semiconducting layer has a thickness of at least 1 nm, more preferably at least 2 nm. The intrinsic organic semiconducting layer has preferably a thickness to at least form a closed layer.

In another preferred embodiment, the intrinsic organic semiconducting layer and the doped organic semiconducting layers are in direct contact to each other.

According to a preferred embodiment, at least one electrode selected from the following group is made of a metallic material: the first electrode, the second electrode, and the gate electrode. The gate electrode can be formed by most metals such as Al, Au, Ag, Ti, Pt, for example. If the first and / or second electrode shall inject electrons it/they may be formed by metals with a low work function, e.g. Ti or Al. If the first and / or second electrode shall inject holes it/they may be formed by metals with a large work function, e.g. Au, Ag, ITO.

According to a further embodiment, the first and second electrode are arranged with respect to the gate electrode such that a projection of each of the first and second electrode onto the gate electrode covers a region that is as large as a width of the first and second electrode, respectively.

According to a preferred embodiment, the doped organic semiconducting layer is configured to form a minority charge carrier channel through which minority charge carriers can move between the first electrode and the second electrode. The minority charge carriers can move from the first electrode to the second electrode and vice versa.

Description of preferred embodiments of the invention

In the following the invention will be described in further detail, by way of example, with reference to different embodiments. In the figures show:

Fig. 1    a schematic representation of an inversion OFET,
Fig. 2    a schematic representation of an inversion OFET with a top contact bottom gate structure,
Fig. 3    a schematic representation of an inversion OFET with bottom contacts,
Fig. 4    a schematic representation of an inversion OFET with a top gate structure,
Fig. 5    characteristics of an inversion OFET, and
Fig. 6    a plot of Eq. 2 for realistic parameters.

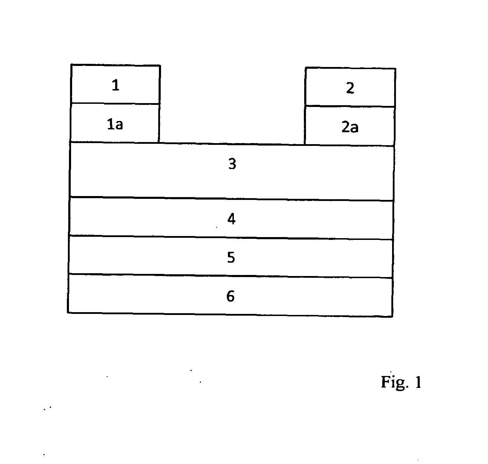

Fig. 1 shows a schematic representation of an inversion OFET. The transistor comprises a first electrode (1), a second electrode (2), a first injection layer (1a), a second injection layer (2a), an intrinsic organic semiconducting layer (3), a doped organic semiconducting layer (4), a gate insulator (5), and a gate electrode (6). The first and second injection layers (1a, 2a) are either n-doped or p-doped. The doped organic semiconducting layer (4) is p-doped if the injection layers are n-doped or n-doped if the injection layers are p-doped. Between the gate insulator (5) and the doped organic semiconducting layer (4) a depletion region is formed.

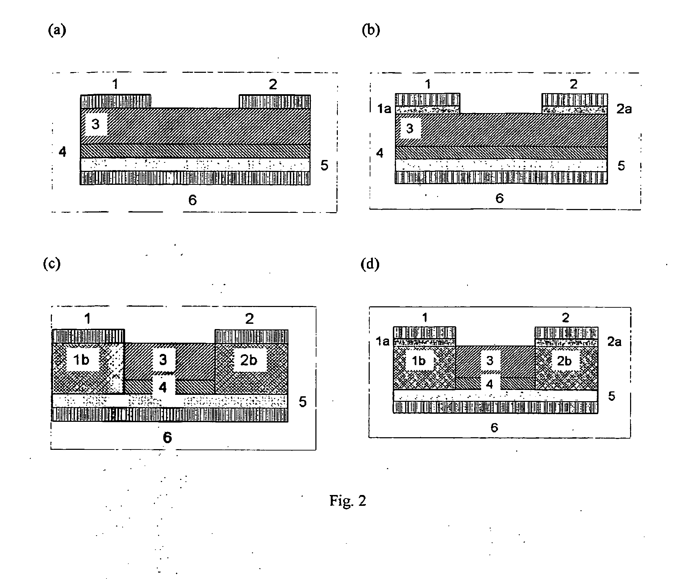

In Fig. 2 the inversion FET is realized by a top contact bottom gate structure. The transistor comprises a source electrode (1), a drain electrode (2), an intrinsic (undoped) organic semiconductor (3), a doped organic semiconductor (4), a gate insulator (5) and a gate electrode (6) (Fig. 2a, not forming part of the invention). The source and drain electrodes (1, 2) can either inject electrons or holes into the semiconductor. The thickness of the doped layer has to be small (2-10 nm). The thickness of the intrinsic semiconducting layer can vary between 20nm and 100nm. The charge carrier mobility of the intrinsic organic semiconductor (3) has to be large. Possible materials are Pentacene, C60, dinaphtho[2,3-b:2 ,3 -f]thieno[3,2-b]-thiophene (DNTT), or copper phthalocyanine (CuPc). The gate insulator (5) may be formed by $SiO_2$, Al2O3, HfO2, polymethyl-methacrylate (PMMA) or other commonly used gate dielectrics.

To realize electron or hole injecting contacts, additional layers (1a and 2a) are introduced between the source and drain electrodes (1, 2) and the intrinsic organic semiconductor (3) (Fig. 2b). The additional layers (1a, 2a) can be realized by doped injection layers to form an ohmic contact at the interface to the source and drain electrodes (1, 2). The doped layers (1a, 2a) could be realized by LiF, Cs, Ca, $Cr_2(hpp)_4$, or $W_2(hpp)_4$ for n-injecting contacts, as well as $F_4TCNQ$, $MoO_3$, $WoO_3$, or $F_6TCNNQ$, for the p-injecting contacts. The injection layers have top be p-doped, if the doped channel is n-doped or n-doped, if the doped channel is p-doped. The thickness of the doped injections layers can range from 2-50nm. The following materials are suitable as matrix materials for the injection layer: MeO-TPD, Pentacene, C60, The materials can be doped with any dopant listed in Table 1.

To further enhance the injection of electrons or holes into the doped layer (4), a mixed layer (1b, 2b) can be included between the source electrode (1) or injection layer (1a) and the doped layer (4) or between the drain electrode (2) or injection layer (2a) and doped layer (4) (Fig. 2 c) and d)).

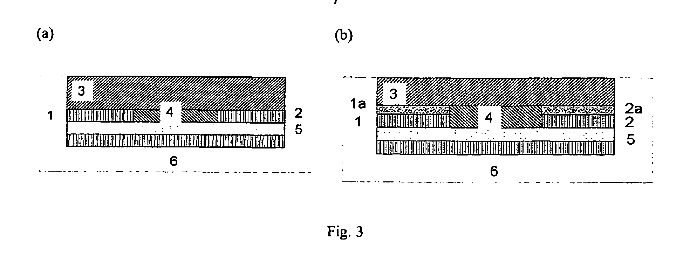

The transistor can also be realized with bottom source/drain contacts as shown in Fig. 3. The transistor comprises the source and drain electrodes (1) and (2), the intrinsic organic semiconductor (3), the doped organic semiconducting layer (4), the gate insulator (5) and the gate electrode (6). The same materials as for the top contact structures shown in Fig. 2 can be used. Again, the source and drain contacts (1, 2) can either be hole or electron injecting. This can be realized by using contacts with adapted work functions (Fig. 3a, not forming part of the invention) or by using doped injection layers (1a, 2a) (Fig. 3b). For an inversion type OFET, the doped layer (4) has to be of p-type for n-type injection contacts and n-type for p-type injection contacts.

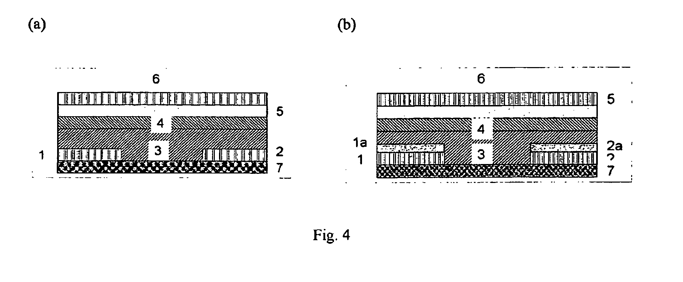

Similarly, the transistors can also be realized in a top-gate structure as shown in Fig. 4. In comparison to bottom-gate structures the doped organic semiconducting layer (4) is deposited on top of the intrinsic organic semiconducting layer (3). Otherwise, the structure is identical to bottom gate structures and the same materials can be used. Again, doped injection layers (1a and 2a) can be used to enhance charge carrier injection at the electrodes (Fig. 4b).

The shift of the threshold voltage of the transistor is even stronger for inversion type OFETs than for depletion type OFETs which is shown in the following.

An inversion type OFET is realized according to Fig. 2b). A glass substrate is coated with a gate electrode (6) consisting of 60 nm of Aluminium. The gate electrode (6) is covered by 120nm $Al_2O_3$ deposited by atomic layer deposition forming a gate insulator (5). On top of the insulator (5), 6nm of pentacene doped with the n-type dopant $W_2(hpp)_4$ (0, 0.5, 1 wt%) forming a doped organic semiconducting layer (4) and 40nm of pentacene forming an intrinsic organic semiconducting layer (3) are deposited by thermal evaporation in UHV conditions (pressure below $10^{-7}$ mbar). The source (1) and drain (2) electrode consist of 50nm Aluminium. To ensure p-type injection into the semiconductor (3, 4), 50nm of pentacene doped with the p-type dopant $F_6TCNNQ$ (4 wt%) are included between the intrinsic layer (3) and the metallic injection layers (1a and 2a). All layers except the $Al_2O_3$ layer are structured by shadow masks. The channel length and width are 30$\mu$m and 20mm, respectively.

The resulting output characteristic of the transistor according to Fig. 2b is shown in Fig. 5a). The transistor is OFF without a voltage applied to the gate (6) and a negative voltage has to be applied to turn the transistor on. The shift of the threshold voltage with n-doping concentration of the doped organic semiconducting layer (4) is shown in comparison to p-type doping in Figure 5 b) and c). It can be seen that the threshold voltage can be tuned by more than 20 V with very low doping concentrations in the doped organic semiconducting layer (4) of only 0.5 wt% and 1 wt%.

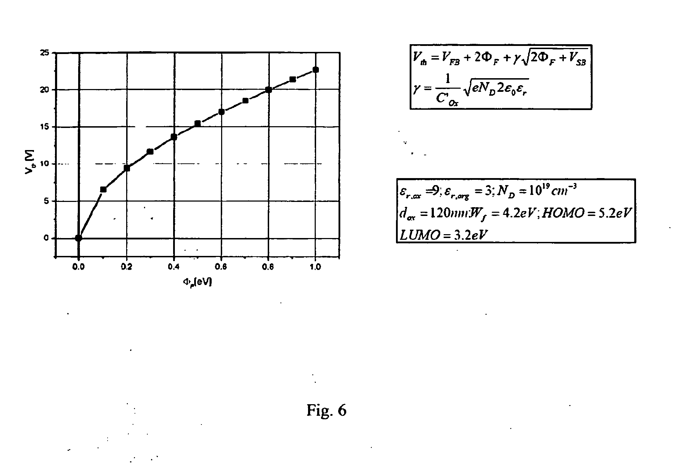

Fig. 6 shows a plot of Eq. 2 for realistic parameters. Fig. 6 shows the predicted shift of the threshold voltage for an inversion OFET. The threshold voltage shifts with the position of the Fermi Level $\Phi_F$ by more than 20V. The position of the Fermi Level can be controlled by the doping concentration in the channel of the transistor. The parameters are: $N_D$ = $10^{19}$ cm$^{-3}$, HOMO = 5.2 eV, LUMO = 3.2 eV, $\varepsilon_{r,ox}$ = 9, $\varepsilon_{r,org}$ = 3, $d_{ox}$ = 120 nm, $W_F$= 4.2 eV.

## Claims

1. An organic field effect transistor, comprising:

   - a first electrode (1) and a second electrode (2), the electrodes providing a source electrode and a drain electrode,
   - an intrinsic organic semiconducting layer (3) in electrical contact with the first and second electrode (1, 2),
   - a gate electrode (6),
   - a gate insulator (5) provided between the gate electrode (6) and the intrinsic organic semiconducting layer (3), and
   - a doped organic semiconducting layer (4) provided between the gate insulator (5) and the intrinsic organic semiconducting layer (3),

   wherein a charge carrier channel between the first and second electrode (1, 2) is formed in the doped organic semiconducting layer (4),

**characterized in that** an injection layer (1a 2a) is provided between the charge carrier channel and at least one of the first and second electrode (1, 2), wherein the infection layer (1a, 2a) is doped with a dopant of opposite type than a dopant of the doped organic semiconducting layer (4).

2. Transistor according to claim 1, wherein the intrinsic organic semiconducting layer (3) and the doped organic semiconducting layer (4) comprise the same organic matrix material.

3. Transistor according to claim 1 or 2, wherein at least one of the first and second electrode (1, 2) is configured to inject minority charge carriers into the charge carrier channel.

4. Transistor according to one of the preceding claims, wherein a mixed layer comprising a hole transport material and an electron transport material is provided in electrical contact with at least one of the first and second electrode (1,2).

5. Transistor according to one of the preceding claims, wherein the thickness of the doped organic semiconducting (4) layer is between 1 nm and 20 nm.

6. Transistor according claim 5, wherein the thickness of the doped organic semiconducting layer (4) is between 2 nm and 10 nm.

7. Transistor according to one of the preceding claims, wherein the intrinsic organic semiconducting layer (3) and the doped organic semiconducting layer (4) are in direct contact to each other.

8. Transistor according to one of the preceding claims, wherein at least one electrode selected from the following group is made of a metallic material: the first electrode (1), the second electrode (2), and the gate electrode (6).

9. Transistor according to one of the preceding claims, wherein the doped organic semiconducting layer (4) has a dopant concentration of up to 4 wt%.

10. Transistor according to claim 9, wherein the doped organic semiconducting layer (4) has a dopant concentration between 0.5wt% and 2wt%.

11. Transistor according to one of the preceding claims, wherein the first and second electrode (1, 2) are arranged with respect to the gate electrode (6) such that a projection of each of the first and second electrode (1, 2) onto the gate electrode (6) covers a region that is as large as a width of the first and second electrode (1, 2), respectively.

12. Transistor according to one of the preceding claims, wherein the doped organic semiconducting layer (4) is configured to form a minority charge carrier channel through which minority charge carriers can move between the first electrode and the second electrode (1, 2).

**Patentansprüche**

1. Organischer Feldeffekttransistor aufweisend:

   - eine erste Elektrode (1) und eine zweite Elektrode (2), wobei die Elektroden eine Source-Elektrode und eine Draine-Elektrode bereitstellen,
   - eine intrinsische organische halbleitende Schicht (3), die in elektrischem Kontakt mit der ersten Elektrode und der zweiten Elektrode (1, 2) ist,
   - eine Gate Elektrode (6),
   - ein Gate-Isolator (5), der zwischen der Gate-Elektrode (6) und der intrinsischen organischen halbleitenden Schicht (3) angeordnet ist und
   - eine dotierte organische halbleitende Schicht (4), die zwischen dem Gate-Isolator (5) und der intrinsischen organischen halbleitenden Schicht (3) angeordnet ist,

   wobei ein Ladungsträgerkanal zwischen der ersten und zweiten Elektrode (1, 2) in der dotierten organischen halbleitenden Schicht (4) gebildet ist,
   **dadurch gekennzeichnet, dass** eine Injektionsschicht (1a, 2a), zwischen dem Ladungsträgerkanal und wenigstens einer von der ersten und zweiten Elektrode (1, 2) angeordnet ist, wobei die Injektionsschicht (1a, 2a) mit einem Dotanden eines Typs dotiert ist, welcher zu einem Dotanden der dotierten organischen halbleitenden Schicht (4) entgegengesetzt ist.

2. Transistor nach Anspruch 1, wobei die intrinsische organische halbleitende Schicht (3) und die dotierte organische halbleitende Schicht (4) das gleiche organische Matrixmatrial aufweisen.

3. Transistor nach Anspruch 1 oder 2, wobei wenigstens eine der ersten und zweiten Elektrode (1, 2) konfiguriert ist, Minoritätsladungsträger in den Ladungsträgerkanal zu injizieren.

4. Transistor nach einem der vorangehenden Ansprüche, wobei eine Mischschicht in elektrischem Kontakt mit wenigstens einer der ersten und zweiten Elektrode (1, 2) angeordnet ist, wobei die Mischschicht ein Löchertransportmaterial und ein Elektronentransportmaterial aufweist.

5. Transistor nach einem der vorangehenden Ansprüche, wobei die Dicke der dotierten organischen halbleitenden Schicht (4) zwischen einem 1 nm und 20 nm beträgt.

6. Transistor nach Anspruch 5, wobei die Dicke der dotierten organischen halbleitenden Schicht (4) zwischen 2 nm und 10 nm beträgt.

7. Transistor nach einem der vorangehenden Ansprüche, wobei die intrinsische organische halbleitende Schicht (3) und die dotierte organische halbleitende Schicht (4) in direktem Kontakt miteinander sind.

8. Transistor nach einem der vorangehenden Ansprüche, wobei wenigstens eine Elektrode ausgewählt aus der folgenden Gruppe von Elektroden aus einem metallischem Material gebildet ist: die erste Elektrode (1), die zweite Elektrode (2) und die Gate-Elektrode (6).

9. Transistor nach einem der vorangehenden Ansprüche, wobei die dotierte organische halbleitende Schicht (4) eine Dotandenkonzentration von bis zu 4 Gew% hat.

10. Transistor nach Anspruch 9, wobei die dotierte organische halbleitende Schicht (4) eine Dotandenkonzentration zwischen 0,5 Gew% und 2 Gew% hat.

11. Transistor nach einem der vorangehenden Ansprüche, wobei die erste und zweite Elektrode (1, 2) mit Bezug zur Gate-Elektrode (6) derart angeordnet sind, dass eine Projektion der ersten und zweiten Elektrode (1, 2) auf die Gate-Elektrode (6) einen Bereich umfasst, der so groß ist wie eine Weite der ersten und zweiten Elektrode (1, 2).

12. Transistor nach einem der vorangehenden Ansprüche, wobei die dotierte organische halbleitende Schicht (4) konfiguriert ist, einen Minoritätsladungsträgerkanal zu bilden durch welchen sich Minoritätsladungsträger zwischen der ersten Elektrode und der zweiten Elektrode (1, 2) bewegen können.

**Revendications**

1. Transistor à effet de champ organique, comprenant :

   - une première électrode (1) et une seconde électrode (2), les électrodes fournissant une électrode de source et une électrode de drain,
   - une couche semi-conductrice organique intrinsèque (3) en contact électrique avec les première et seconde électrodes (1, 2),
   - une électrode de grille (6),
   - un isolateur de grille (5) fourni entre l'électrode de grille (6) et la couche semi-conductrice organique intrinsèque (3), et
   - une couche semi-conductrice organique dopée (4) fournie entre l'isolateur de grille (5) et la couche semi-conductrice organique intrinsèque (3),

   dans lequel un canal de porteurs de charge entre les première et seconde électrodes (1, 2) est formé dans la couche semi-conductrice organique intrinsèque (4),
   **caractérisé en ce qu'**une couche d'injection (1a, 2a) est fournie entre le canal de porteurs de charge et au moins l'une d'entre les première et seconde électrodes (1, 2), dans lequel la couche d'injection (1a, 2a) est dopée avec un dopant de type opposé à celui d'un dopant de la couche semi-conductrice organique dopée (4).

2. Transistor selon la revendication 1, dans lequel la couche semi-conductrice organique intrinsèque (3) et la couche semi-conductrice organique dopée (4) comprennent le même matériau de matrice organique.

3. Transistor selon la revendication 1 ou 2, dans lequel au moins l'une d'entre les première et seconde électrodes (1, 2) est configurée pour injecter des porteurs de charge minoritaires dans le canal de porteurs de charge.

4. Transistor selon l'une des revendications précédentes, dans lequel une couche mélangée comprenant un matériau de transport de trous et un matériau de transport d'électrons est fournie en contact électrique avec au moins l'une d'entre les première et seconde électrodes (1, 2).

5. Transistor selon l'une des revendications précédentes, dans lequel l'épaisseur de la couche semi-conductrice organique dopée (4) est comprise entre 1 nm et 20 nm.

6. Transistor selon la revendication 5, dans lequel l'épaisseur de la couche semi-conductrice organique dopée (4) est comprise entre 2 nm et 10 nm.

7. Transistor selon l'une des revendications précédentes, dans lequel la couche semi-conductrice organique intrinsèque (3) et la couche semi-conductrice organique dopée (4) sont en contact direct l'une avec l'autre.

8. Transistor selon l'une des revendications précédentes, dans lequel au moins une électrode sélectionnée dans le groupe suivant est constituée d'un matériau métallique : la première électrode (1), la seconde électrode (2), et l'électrode de grille (6).

9. Transistor selon l'une des revendications précédentes, dans lequel la couche semi-conductrice organique dopée (4) possède une concentration en dopant allant jusqu'à 4% en poids.

10. Transistor selon la revendication 9, dans lequel la couche semi-conductrice organique dopée (4) possède une concentration en dopant comprise entre 0,5 % en poids et 2 % en poids.

11. Transistor selon l'une des revendications précédentes, dans lequel les première et seconde électrodes (1, 2) sont disposées par rapport à l'électrode de grille (6) de manière à ce qu'une projection de chacune des première et seconde électrodes (1, 2) sur l'électrode de grille (6) recouvre une région qui est aussi grande qu'une largeur respective des première et seconde électrodes (1, 2).

12. Transistor selon l'une des revendications précédentes, dans lequel la couche semi-conductrice organique dopée (4) est configurée pour former un canal de porteurs de charge minoritaires à travers lequel des porteurs de charge minoritaires peuvent se déplacer entre la première électrode et la seconde électrode (1, 2).

| 1 | | 2 |
| 1a | | 2a |
| 3 | | |
| 4 | | |
| 5 | | |
| 6 | | |

Fig. 1

(a)

(b)

(c)

(d)

Fig. 2

(a)

(b)

Fig. 3

(a)

(b)

Fig. 4

(a)

(b)

(c)

Fig. 5

$$V_{th} = V_{FB} + 2\Phi_F + \gamma\sqrt{2\Phi_F + V_{SB}}$$

$$\gamma = \frac{1}{C_{Ox}}\sqrt{eN_D 2\varepsilon_0\varepsilon_r}$$

$$\varepsilon_{r,ox} = 9; \varepsilon_{r,org} = 3; N_D = 10^{19} cm^{-3}$$

$$d_{ox} = 120nm; W_f = 4.2eV; HOMO = 5.2eV$$

$$LUMO = 3.2eV$$

Fig. 6

**EP 2 658 006 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2006040548 A2
- US 20090315455 A1
- US 20060033098 A1
- US 20050242342 A1
- WO 2009062457 A1
- US 2005040390 A1
- US 2009179189 A

### Non-patent literature cited in the description

- **MEIJER et al.** *Journal of Applied Physics,* 2003, vol. 93 (8), 4831
- **HUANG et al.** *Journal of Applied Physics,* 2006, vol. 100 (11), 114512
- **GAO et al.** *Appl. Phys. Lett.,* 2001, vol. 79, 4040
- **BLOCHWITZ et al.** *Appl. Phys. Lett.,* 1998, vol. 73, 729
- **D'ANDRADE et al.** *App. Phys. Let.,* 2003, vol. 83, 3858
- **WALZER et al.** *Chcm. Rev.,* 2007, vol. 107, 1233